**Europäisches Patentamt**

**European Patent Office**

**Office européen des brevets**

(19)

(11) **EP 1 263 128 A2**

(12) **EUROPEAN PATENT APPLICATION**

| | |
|---|---|
| (43) Date of publication:<br>**04.12.2002 Bulletin 2002/49** | (51) Int Cl.⁷: **H03B 28/00** |

(21) Application number: **02253436.6**

(22) Date of filing: **16.05.2002**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventor: **Shipley, Adrian**<br>**Dudley, West Midlands, DY1 2 JU (GB)** |
| (30) Priority: **23.05.2001 GB 0112639** | (74) Representative: **Beck, Simon Antony et al**<br>**Withers & Rogers,**<br>**Goldings House,**<br>**2 Hays Lane**<br>**London SE1 2HW (GB)** |
| (71) Applicant: **Lucas Industries Limited**<br>**West Midlands B90 4LA (GB)** | |

(54) **Sinusoid synthesis**

(57)     An approximate sinusoid is synthesised by subtracting the error between a periodic signal, for example a triangle wave, and a true sinusoid. The periodic signal is produced using a counter circuit, while the error signal is generated using a shift register circuit, both circuits being clocked by a common clock signal.

An improved approximation to the sine wave may be achieved by further generating an error signal approximating to the error between the first generated approximate sine wave and a true sine wave, approximate error signal being generated in the same fashion using a counter circuit and shift register clocked from a common clock signal, the second error signal being combined with approximate sine wave to produce an improved sine wave.

*Fig. 1*

## Description

The present invention relates to a method of and apparatus for generating an approximation of a sinusoid.

In many electronic circuits there is often a requirement to synthesise a pure sine wave, for example to be used as a reference signal. Digital synthesis of a sine wave is often employed. A digital synthesis of a sine wave is normally achieved by storing sample points of the sine wave in memory, then repetitively retrieving the stored sample points in sequence from the memory, or "playing back" the memory, to produce a pseudo time continuous waveform. A disadvantage of this technique is that the memory used to store the sample points of the sine wave cannot be used for other purposes, thus potentially reducing the flexibility of the system in which the synthesis is used. A further disadvantage can occur in certain systems or circuits where a long service life is required and the components must be both robust and replaceable. Memory technologies are short lived, and consequently there is a significant risk that replacement components may not be available after a few years. This is particularly disadvantageous for avionics systems where changing components may require re-approval of the equipment for use.

An example of the "playback" memory technique is described in UK patent number 1410905 that discloses a circuit having two ROMs, each ROM storing the binary codes corresponding to the sine of an input binary value for the first quadrant of an arc. By simultaneously counting of the ROM, sine and cosine signals are generated simultaneously.

It is also known to generate approximate sine waves, and other functions, by summing a number of clocked signals together. An example of this technique is disclosed in GB 2338852 that describes a synthesis of a sine wave using pulse width modulated (PWM) wave forms. A stepped approximation to a sine wave is generated by adding weighted PWM signals having the same frequency as the desired sine wave. The PWM wave forms are generated from an input clock signal so that the frequency of the output sine wave is adjustable by varying input clock frequencies. However, mixing PWM wave forms in this manner produces high frequency components in the output sine wave that are highly undesirable and that require a low pass filter to remove them. The presence of the low pass filter in the circuitry has the effect that the amplitude of the output signal is not well defined with frequency. The complexity of the required circuitry is also increased.

It would therefore be advantageous to provide a method and apparatus for generating a sine wave that does not require the use of stored sample points in memory and uses instead basic digital building blocks that are easily available and are known to be robust in operation.

According to a first aspect of the present invention there is provided a method of generating an approximate quarter sinusoid, the method comprising: generating at least a quarter cycle of a periodic signal; generating a first error signal approximating to the error between said quarter cycle of said periodic signal and a true quarter of a sinusoid; and combining said first error signal with said periodic signal to provide a first representation of a quarter sinusoid, wherein the first error signal is generated as a function of a shift register operation or an offset ramp operation.

According to a second aspect of the present invention there is provided apparatus for generating an approximate quarter sinusoid, comprising: a signal generating circuit arranged to provide at least a quarter cycle of a periodic signal; a first error generating circuit arranged to provide an error signal approximating to the error between said quarter cycle of said periodic signal and a true quarter of a sinusoid; and a signal combining circuit arranged to combine said first error signal and said quarter cycle of said periodic signal to provide a first representation of a quarter sinusoid, wherein the first error generating circuit comprises at least one clocked shift register or an offset ramp generator

It is therefore possible to provide a first representation of a quarter sinusoid using simple circuitry, with the advantage that the amplitude of the sinusoid is established as a function of the amplitude of the signals used to generate it and moreover remains fixed as a clock frequency, and hence the sinusoid frequency, is varied. This is not the case with prior art circuitry that use one or more filters to remove unwanted frequency components.

In the context used herein, "simple" in relation to circuitry means that only well established circuit components are used such as counters and shift registers. These components have remained readily available since the 1970's and can reasonably be expected to remain available.

Preferably the signal generated by the signal generating circuit is a substantially linear ramp during a quarter cycle of the sinusoid. Thus the signal is a triangle wave when viewed over longer periods. Such ramp or triangle signals can be generated to high accuracy by the counting up, or up and down, of a counter.

Preferably, a second error signal may be generated approximating to the error between the approximate sinusoid and a true sinusoid, the second error signal being combined with the first representation to provide an improved second representation of a true sinusoid. It is further preferred that an error signal approximating to the error between the improved second representation and a true sinusoid is produced for each of a subsequent plurality of improved representations of a true sinusoid in an iterative manner, thereby iteratively improving the representation of the true sinusoid.

The first error signal may be represented as a curve substantially of the form $y=2^n-1$ where n is a positive integer. Such a curve can be approximated by successively shifting logical ones into a shift register.

Alternatively, the first error signal may be generated by summing a plurality of ramped signals. Preferably, the ramped signals are time delayed with respect to one another. The time delay may be either uniform or non-uniform. Furthermore, the gradient of at least two of the plurality of ramped signals may be different from one another.

According to a third aspect of the present invention there is provided an apparatus for digitally generating an approximation of a sinusoid, the apparatus comprising means for generating in a quarter cycle of the sinusoid a plurality of shifted representations of a linear ramp signal, and summing means for combining the plurality of time shifted representations so as to synthesise an approximation of a sinusoid.

The ramp signals may be generated by a counter. The time shifting may be achieved by commencing clocking of different ones of the counters at different times measured with respect to the commencement of a quarter or half cycle of the sinusoid. The delay may be formed by shifting the clock signal through a series of initially cleared shift registers. However it is also possible that the delay may also be implemented by using a gate and counter combination to inhibit clocking of a ramp generator until a predetermined number of clock cycles from a master clock or from a preceding stage in a cascade of stages has occurred.

Preferably, a complete approximate sinusoid may be generated by reversing the rate of change of the signals with respect to time. Thus this "reversal" generates the second quarter cycle of a digitally generated sinusoid. The third and fourth quarter cycles are formed by repeating the generation of the first and second quarter cycles but with the sine of the output reversed, thus generating the other half cycle.

The present invention will now be described, by way of example, with reference to the accompanying figures, in which:

Figure 1 shows a periodic triangle wave that provides an approximation to a sine wave;

Figure 2 is a plot of the error function between the triangle wave and sine wave shown in Figure 1;

Figure 3 shows a circuit for producing a first order representation of a sine wave in accordance with embodiments of the present invention;

Figure 4 shows a plot of the first order representation produced by the circuit of Figure 3, together with a plot of a true sine wave;

Figure 5 is a plot of a further first order representation which has been deliberately chosen so as to facilitate second order correction.

Figure 6 shows a plot of the error function of the approximate sine wave produced by the circuit of Figure 5 compared to a true sine wave;

Figure 7 shows part of a periodic triangle wave that approximates to the error function of Figure 6;

Figure 8 shows a circuit in accordance with the present invention that provides an improved approximation of a sine wave;

Figure 9 schematically illustrates the generation of the error function according to a further embodiment of the present invention;

Figure 10 shows a plot of an approximate sine wave generated using an error function shown in Figure 9; and

Figure 11 shows a circuit in accordance with a further embodiment of the present invention that provides an improved approximation of a sine wave using the error function as shown in Figure 9.

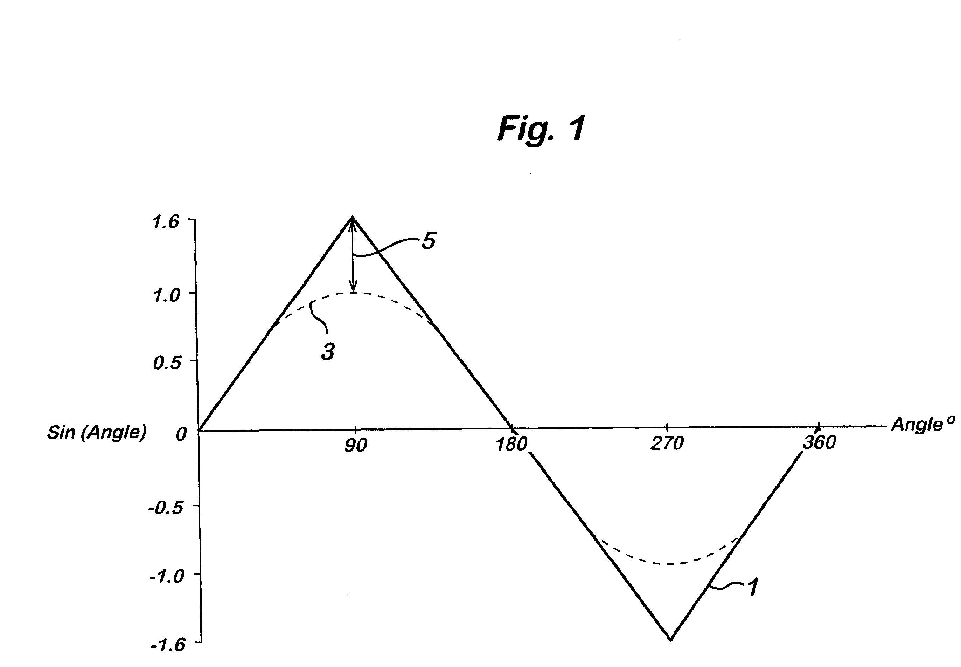

The purpose of the present invention is to provide a high quality digital approximation of a sinusoid using as simple a representation as possible. An example of a simple representation of a sine wave is a triangle wave form. Figure 1 shows a triangle wave form 1 during a single period thereof (360°). Also shown in Figure 1 is a true sine wave 3 (shown in chained line). It can be seen from Figure 1 that if the gradient and intercept of the triangle waveform is set equal to the gradient and intercept of the sine wave at 0°, then at certain points over the 360° period there is a significant error between the true sine wave 3 and the triangle wave 1. The error at 90° is shown by the double headed arrow 5 in Figure 1. The error between the triangle wave and sine wave varies through the 360° period.

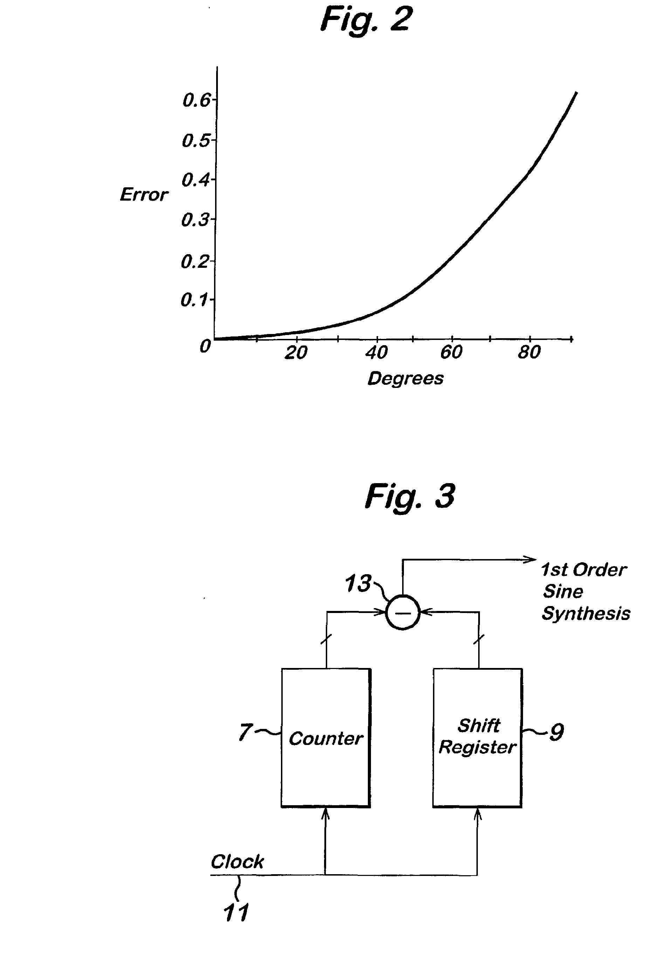

Figure 2 shows the error between the triangle wave and sine wave plotted against the first 90° of the period shown in Figure 1. The error varies between 0 and 0.57 over a quarter of one period. It will be appreciated that by subtracting the error from the triangle wave 1 an approximate sine wave will be generated.

It can be seen that this error function varies smoothly and monotonically. The error function is essentially an exponential function and can therefore be approximated using the equation, error = $2^N$, where N equals a number of samples used to synthesise the sine wave. Alternatively the error function may be approximated as $2^N - 1$. This allows the error function to be very easily produced using a shift register. A clocked shift register having an input set to a logic high level, e.g. 1, will "fill up" with ones on each clock pulse. If each clock pulse represents a sample, or N, then it will be seen that the contents of the shift register will equal $2^N - 1$.

Equally, the triangle wave 1 shown in Figure 1 can easily be produced using a clocked counter. Therefore, an approximation of a sine wave can be produced using simply a counter and shift register, the required approximate sine wave being the difference between the outputs of the counter and shift register. Such an arrangement is shown in Figure 3.

Figure 3 shows a clocked counter 7 and a clocked shift register 9 clocked using the same clock signal 11. The output of the shift register is subtracted from the output of the counter using a signal combiner 13 (such as an adder), the output of the signal combiner being an approximate sine wave.

It will be appreciated that the maximum length of binary word produced by the counter 7 and the depth of the shift register 9 must be equal and equates to the number of samples required to generate an acceptable approximation of a sine wave.

It will also be appreciated that it is only necessary to be able to generate a quarter cycle of a sine wave i.e. 0°-90°, as the remaining quarters of the sine wave can be generated by either reversing the direction of count of the count circuit and arranging for the shift register shift in the opposite direction, i.e. to shift in zeros starting with the most significant bit, and/or changing the sine of the signals produced by the counter and shift register. For example, for 0°-90° and 180°-270° the counter 7 must be arranged to count upwards. However, for 90°-180° and 270°-360° the counter must count downwards and the contents of the shift register "rewound". Also, during 180°-360° a sign bit, for example the most significant bit of the final output may be set so as to provide a negative sign during this phase.

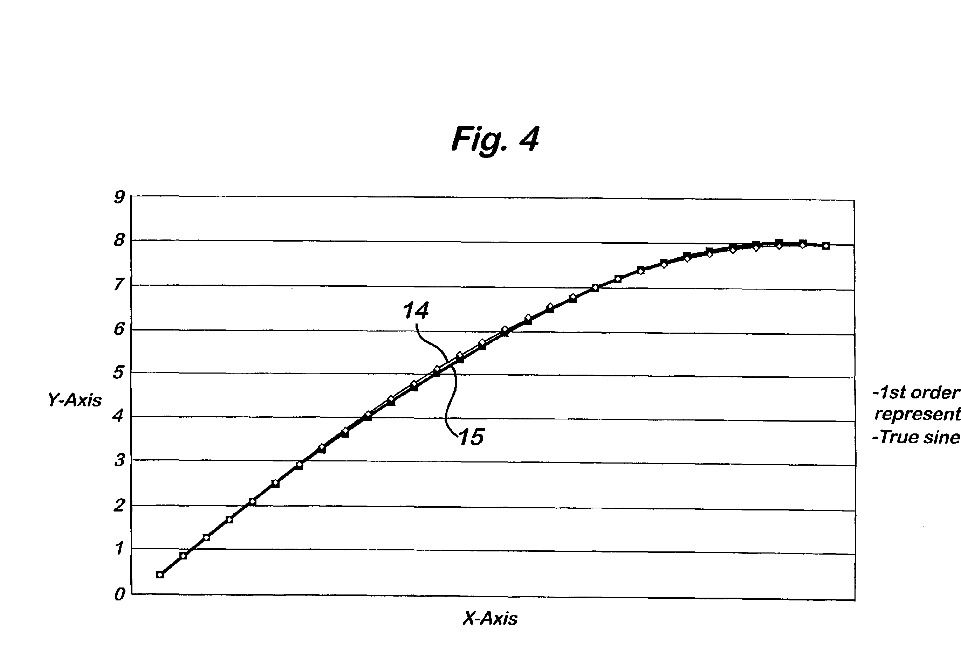

Although the apparatus of Figure 3 produces a relatively accurate first order representation of a sine wave in a simple and robust manner, there is nonetheless an error between the first order representation of a sine wave and a true sine wave. This can be seen from Figure 4 which shows both a true sine wave 14 given by Y=8sin0.17$\pi x$ and the first order representation 15 having the formula Y=5$x$-(2$^x$-1) generated by the circuit of Figure 3 plotted over the first quarter cycle. The error for this circuit is typically less than 1%. However, it is possible to provide higher accuracy approximations provided that the error function between the true sinusoid and the first order approximation can itself be synthesised.

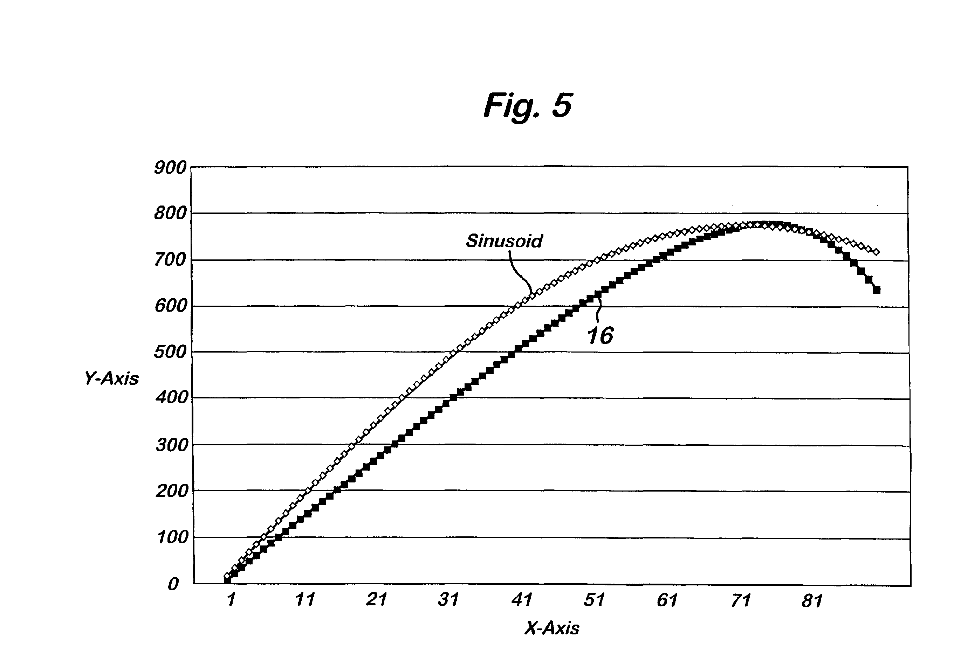

Figure 5 shows a further first order approximation that may be produced using the circuit shown in Figure 3. In this example the first order approximation 16 is generated using an equation which deliberately induces an error which itself approximates a sinusoid or a triangle wave. In the example shown in Figure 5, the first order approximation is generated from the equation

$$y = 128 \; x\text{-}(2^x - 1)$$

whereas the sinusoid is represented by

$$y = 775\sin((\pi x)/14.5)$$

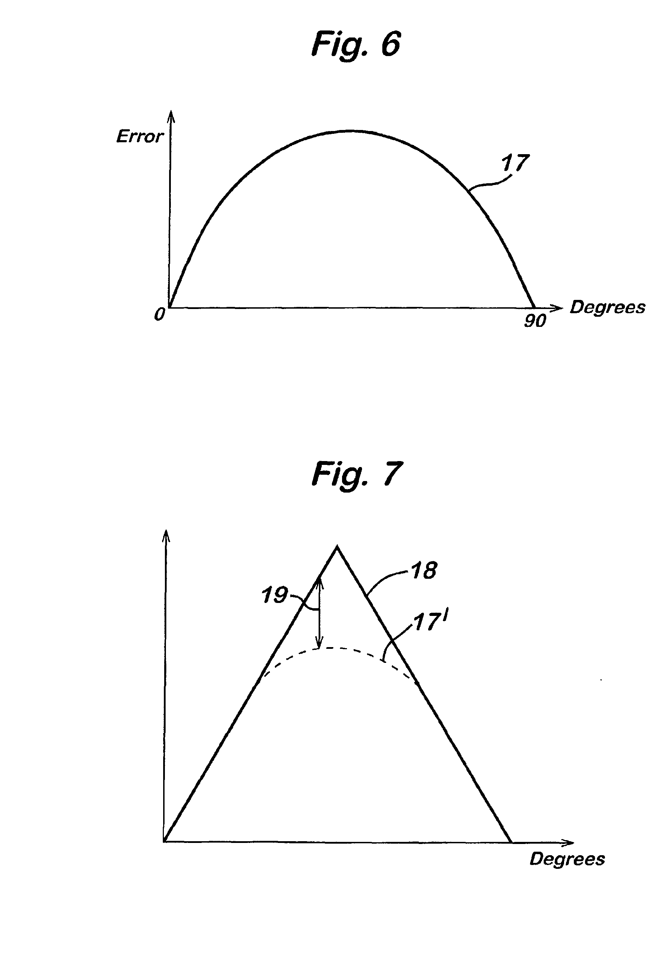

The error between the two waveforms can be generated from an appropriate error function. Plotted over the first 90° of a complete cycle, the error function 17 is approximately as shown in Figure 6. In exactly the same manner as the sine wave 3 of Figure 1 can be approximated with a triangle wave 1, as shown in Figure 1, the error function 17 for the approximation, shown in Figure 6 can also be approximated by a triangle waveform. This is represented in Figure 7 where the error function 17 of Figure 6 is shown in chain line 17' and a triangle wave 18 approximating to the error function is also shown superimposed upon the error function. It can therefore be seen that the triangle wave 18 provides an approximation to the error function 17.

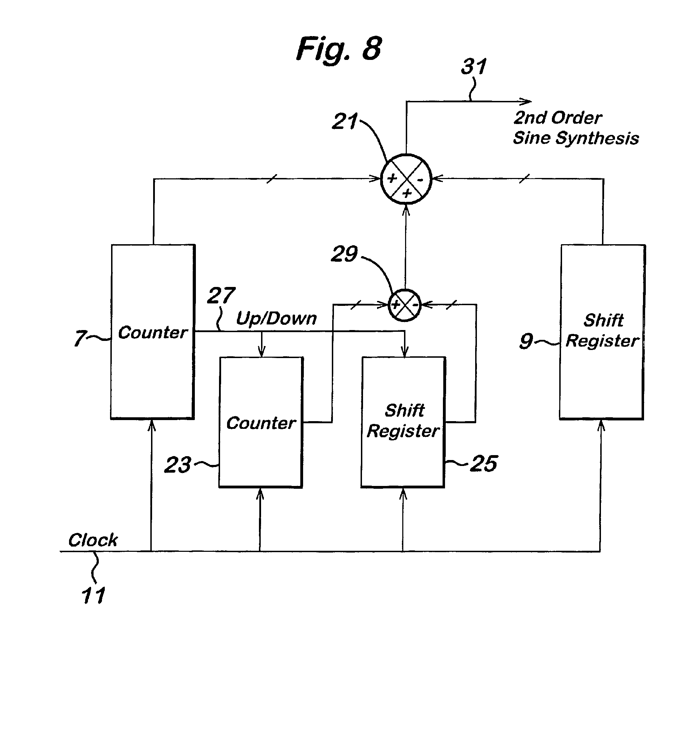

Again, in the same manner as shown in Figure 1 by subtracting the difference 19 between the triangle wave 18 and the error function 17' from the triangle wave 17 a close approximation of the error function can be achieved. If this approximate error function 17' is subtracted from the first order sine wave produced by the circuit shown in Figure 3, an improved second order sine wave can be generated. The only point of difference is that the triangle wave 17 used to generate the second order error signal is twice the frequency of the triangle wave 1 used in the first stage to produce the first order sine wave. Figure 8 shows a circuit arrangement that can be used to generate an improved (second order) approximate sine wave in accordance with the present invention. Counter 7 and shift register 9 are clocked using a clock signal 11 and are combined at an adder 21 (replacing adder 13 of Figure 3) in exactly the same manner as for Figure 3. An additional counter 23 and shift register 25 are provided, clocked from the same clock signal 11 as counter 7 and shift register 9. Although counter 23 and shift register 25 are clocked at the same frequency as counter 7 and shift register 9, counter 23 and shift register 25 are arranged to generate their outputs at twice the frequency as counter 7 and shift register 9. That is to say, the number of clock cycles required by counter 23 to go from its minimum to maximum output is exactly half that required for counter 7. An up/down signal 27 is provided to both the counter 23 and shift register 25 from the first counter 7 to ensure that a second counter 23 and second shift register 25 are "reversed" at twice the frequency of the first counter 7 and first shift register 9. The up/down signal 27 toggles each time the first counter passes through its mid count value. A second adder 29 combines the output of the second counter 23 and second shift register 25 to generate an approximation of the error between the first order approximation of a sine wave generated by the first counter 7 and first shift register 9 and a true sine wave. This error signal is subsequently combined at the adder 21 to thereby produce an improved approximate sine wave signal that the output of 31 of the adder 21.

It will be appreciated by those skilled in the art that further error signals can be generated approximating to the error between the generated sine wave and a true sine wave in exactly the same manner as many times as is required to achieve the desired accuracy of generated sine waves.

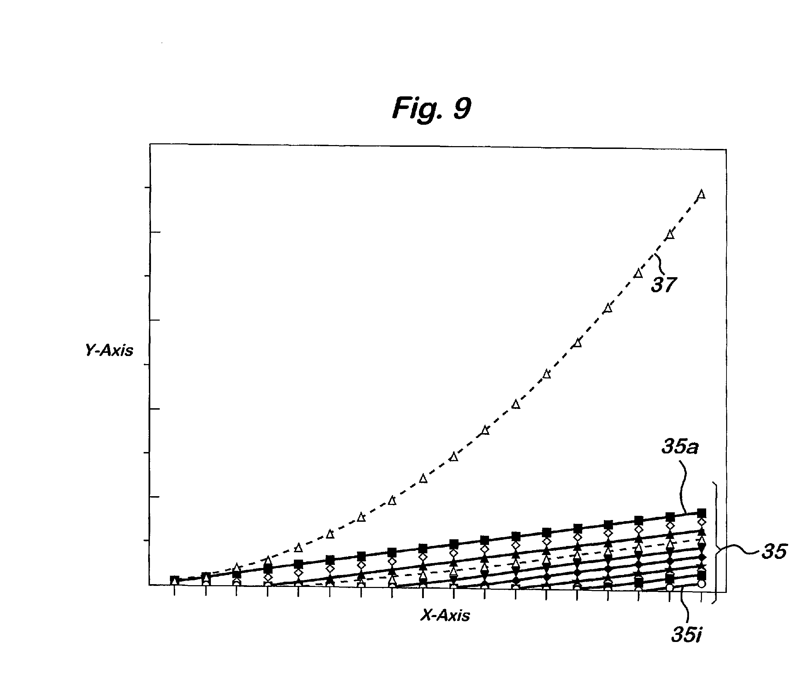

A further embodiment of the present invention that provides higher accuracy approximations to a true sine wave is described with reference to figures 9, 10 and 11. An alternative method for generating the desired error function to be subtracted from the linear ramp signal output from the counter is illustrated with reference to figure 9. The desired error function may be generated by adding together a plurality of ramp signals, each one of the ramp signals being time delayed with respect to one another. In the example shown in figure 9, nine ramp functions 35a to 35i are shown, each being the same gradient as one another but being time delayed along the X-axis by two units. By simply summing the value of all of the ramp functions 35 at any given point along the X-axis, an improved error function 37 is obtained. The accuracy and resolution of the generated error function can be varied as desired by varying either the time delay between each ramp function or varying the gradient of the functions, or both. Furthermore, the time delay between these ramp (straight line) functions may be either uniform or non-uniform, and similarly the gradients of each of the ramp functions may differ from one another or alternatively be identical.

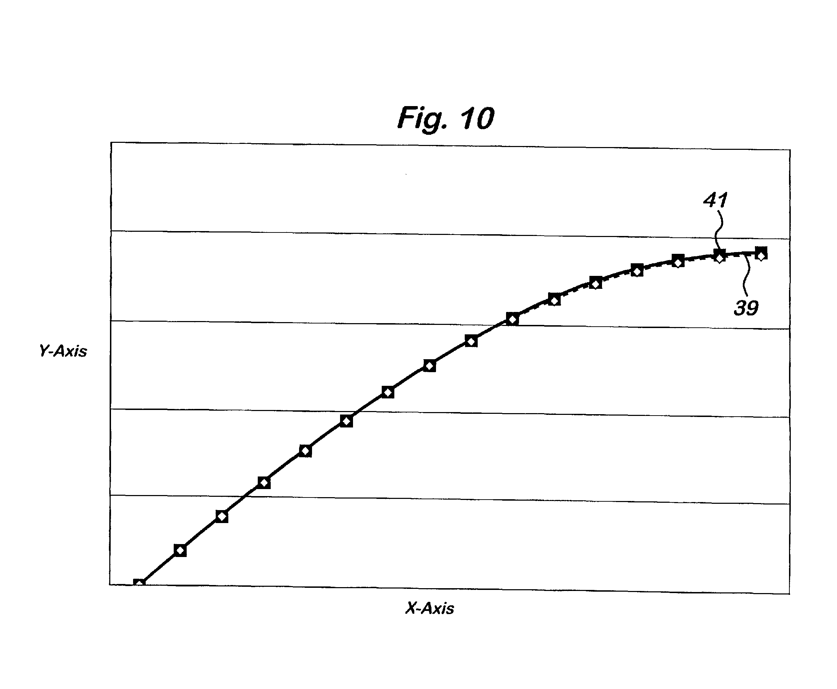

An example of an approximate sine wave generated using this method is shown in Figure 10, together with a fitted true sine wave for comparison. The true sine wave is represented by the lower trace 39 on Figure 10, with the approximate sine wave generated by this embodiment of the present invention shown by the upper trace 41. The actual equation for the sinusoid fitted to the generated approximate sine wave is

$$y = a * b \times \cos (cx + d),$$

Where

a= 0.00093540362
b = 38400.001
c = 0.010334868 and
d = -1.5707963

Thus it can be seen that the coefficients "a" is very small and "d" introduces a phase shift of $\pi/2$ radians. Thus the generated sinusoid is very close to a mathematically perfect sinusoid.

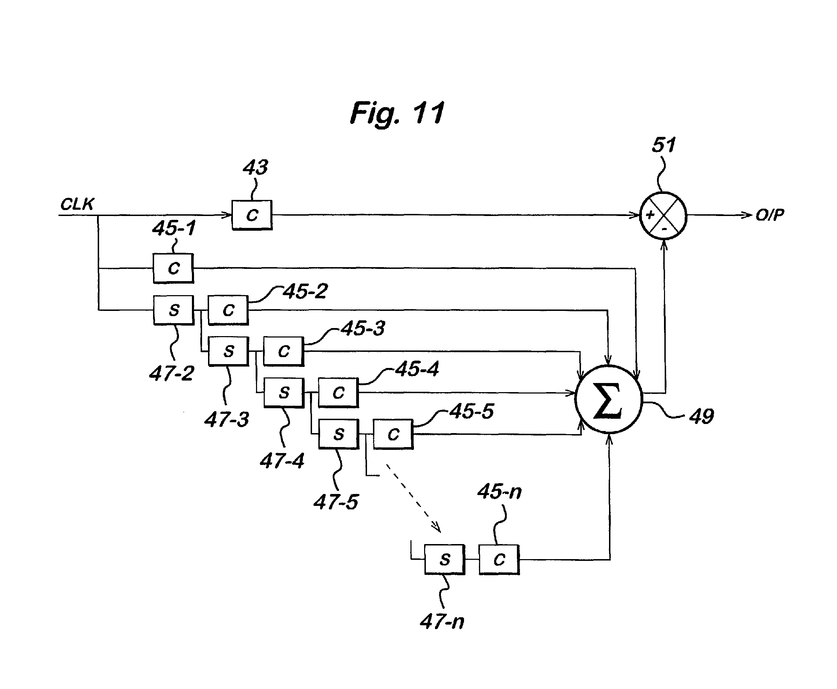

The digital synthesis of the error function according to this embodiment of the present invention and the architecture for the generation of the approximate digital sine wave is illustrated in Figure 11. A clocked input signal is provided to a first counter 43, which provides the linear ramp function from which the generated error signal is to be subtracted. A plurality of subsequent counters 45-1 to 45-n are also provided to generate the plurality of ramp functions. With the exception of the first of these additional counters 45-1, which directly receives a clock signal as an input, each of the subsequent additional counters 45-2 to 45-n have their inputs connected to the output of an associated shift register 47-2 to 47-n. The input of the first shift register 47-2 is coupled directly to the clock signal. Each subsequent shift register 47 has their input connected to the output of the previous shift register 47, ic input of register 47-3 is connected to output of register 47-2, and so on. Hence the shift registers 47-2 to 47-n generate the time delay between each of the ramp functions generated by the counters 45-1 to 45-n. The output of each of the counters is input to a summation circuit 49, which performs a cumulative addition. The output of the summation circuit 49 is input to the negative input of a second summation circuit 51. The positive input of the summation circuit 51 is coupled to the output of the first counter 43 generating the first linear ramp function. Hence the second summation unit 51 subtracts the summed output of the first summation unit 49 from the linear ramp function generated by the first counter 43 to provide an output providing an improved approximate digital sine wave.

In one embodiment, the initial counter 43 generating the first linear ramp function counts in steps of 512, with the remaining subsequent counters 45 counting in steps of 32. Each shift register delays the clock signal to its associated counter by 10 clock cycles. As previously described, in alternative embodiments the delays generated by the shift registers may vary and may be different from one another, as may the steps in which the subsequent counters 45 counting, which determines the gradient of the ramp function generated by each counter.

From initialisation, the counters count upwardly, with each of the counters 45-1 to 45-n starting counting at different times. Each of the counters 43 and 45-1 to 45-n is reversible. Once a full quarter cycle of the sinusoid has been generated, the counters are then switched to count down. Each counter is configured such that it does not reach its maximum count during the first quarter of the sinusoid and also such that it stops counting once it counts down to zero. Thus the counters accurately "reverse" the function used to generate the first quarter of the sinusoid.

After each half sinusoid is completed a "reset" is performed on the shift registers via a reset device (not shown) such that the time delays of the various ramp signals can be reintroduced.

In a further alternative, the plurality of counters 45-1 to 45-n may be arranged to be initially loaded with offset values corresponding to extrapolations of their individual ramp functions back to time t=0 representing the commencement of the sinusoid. The counters are signed such that they can count above and below zero but each counter is further arranged such that its output is set to zero if the value within the counter is negative. This can be achieved by testing the value of the counter by examining a sign bit and using this to operate a subsequent gating or buffer interposed between the counter and the summer 49.

This invention offers an expandable way for generating the error function for sine wave generation to a high degree of resolution accuracy. High resolution and accuracy are required for such applications as the demodulation of resolvers. Although the gate count is proportional to the number of gates used, it is still less than the equivalent number of gates required in a memory mapped method of producing the sine wave.

The present invention therefore can provide a synthesised sine wave using simple digital circuitry and without the use of memory circuits.

**Claims**

1. A method of generating an approximate quarter sinusoid, the method comprising:

   generating at least a quarter cycle of a periodic signal (1);
   generating a first error signal (37) approximating to the error between said quarter cycle of said periodic signal and a true quarter of a sinusoid; and
   combining said first error signal with said periodic signal to provide a first representation of a quarter sinusoid, **characterised in that** the first error signal is generated as a function of a shift register operation or an offset operation (9;47).

2. A method of generating an approximate quarter sinusoid, according to claim 1, further comprising:

   generating a second error signal approximating to the error between said first representation and said true quarter sinusoid; and
   combining said second error signal from said first representation to provide an improved second representation to said true quarter sinusoid.

3. A method of generating an approximate sinusoid according to claim 1, wherein said first error signal (37) is generated by summing a plurality of ramped signals (35).

4. A method of generating an approximate sinusoid according to claim 3, wherein said plurality of ramped signals (35) are displaced with respect to each other.

5. A method of generating an approximate sinusoid according to claim 4, wherein said displacement is non-uniform.

6. A method of generating an approximate sinusoid according to any one of claims 3 to 5, wherein the gradient of at least two of said plurality of ramped signals (35) are different from one another.

7. A method of generating an approximate quarter sinusoid according to any preceding claim, wherein said quarter cycle of said periodic signal (1) is generated by a clocked circuit.

8. A method of generating an approximate quarter sinusoid according to claim 7, wherein said quarter cycle of said periodic signal (1) is generated by a counter circuit (7; 43).

9. A method of generating an approximate quarter sinusoid according to any preceding claim, wherein said quarter cycle of said periodic signal (1) is a ramped signal.

10. A method of generating an approximate sinusoid, the method comprising:

    i) generating the first quarter cycle of a sinusoid according to the method of claims 1 to 9.
    ii) generating the second quarter cycle of said sinusoid by reversing the rate of change of the signals with respect to time.
    iii) generating the subsequent half cycle of said sinusoid by repeating steps i) and ii) and reversing the sign of the resulting approximate half signal.

11. A method of generating an approximate sinusoid according to claim 10, wherein said periodic signal is generated by a count up/count down circuit.

12. A method of generating an approximate sinusoid according to claim 10 or 11, wherein said periodic signal is a triangle wave.

13. A method of generating an approximate sinusoid according to claim 10, 11 or 12, wherein said first error signal is generated by a shift register circuit arranged to be shifted in either direction.

14. An apparatus for generating an approximate quarter sinusoid, comprising:

    a signal generating circuit arranged to provide at least a quarter cycle of a periodic signal (7; 43);
    a first error generating circuit (9) arranged to provide an error signal approximating to the error between said quarter cycle of said periodic signal and a true quarter cycle of a sinusoid; and

a signal combining circuit (13; 51) arranged to combine said first error signal and said quarter cycle of said periodic signal to provide a first representation of a quarter sinusoid,

**characterised in that** said first error generating circuit (a) comprises at least one clocked shift register or at least one offset ramp generator.

15. An apparatus according to claim 14, further comprising at least one second error generation circuit (9, 25) arranged to provide a second error signal approximating to the error between said first representation and said true quarter sinusoid, wherein said signal combining circuit (13) is further arranged to combine said second error signal with said first representation to provide an improved second representation to said true quarter sinusoid,

16. An apparatus according to claim 14, wherein said first error generating circuit comprises:

a plurality of counter circuits (45), each counter circuit being arranged to produce a ramped output signal;

a plurality of clocked shift registers (47), each clocked shift register being arranged to provide an input signal to a respective one of said plurality of counter circuits (45), whereby said input signals are time delayed with respect to one another; and

a summation circuit (49) arranged to receive the ramped output signals and combine said signals to generate said error signal.

17. An apparatus according to claim 16, wherein said clocked shift registers (47) are arranged to provide said input signals at a non-uniform time delay with respect to one another.

18. An apparatus according to claim 17, wherein said clocked shift registers (47) are arranged in a cascade.

19. An apparatus according any one of claims 16 to 18, wherein at least two of said counter circuits (45) are arranged to produce ramped output signals having differing gradients from one another.

20. An apparatus according to any one of claims 14 to 19, wherein said signal generating circuit (7, 43) is a clocked circuit.

21. An apparatus according to claim 20, wherein said signal generating circuit (7, 43) is a counter circuit.

22. An apparatus according to any one of claims 14 to 21, wherein said quarter cycle of said periodic signal is a ramped signal.

23. An apparatus according to claim 15, wherein the first and second error generation circuits and said signal generating circuit are clocked at the same frequency.

24. An apparatus for generating an approximate sinusoid, comprising apparatus for generating an approximate quarter cycle of a sinusoid according to any one of claims 14 to 23, wherein said signal generating circuit (7, 43) and said first error generating circuit (9) are arranged to reverse the rate of change of the signals with respect to time every quarter of a cycle, and said signal combining circuit is arranged to reverse the sign of the provided first representation every half cycle.

25. An apparatus according to claim 24, wherein said signal generating circuit (7, 43) comprises an up/down counter.

26. An apparatus according to claim 24 or 25, wherein said periodic wave is a triangle wave.

27. An apparatus according to any one of claims 24, 25 or 26 wherein said first error generating circuit (9) comprises a shift register arranged to be shifted in either direction.

28. An apparatus for generating an approximation of a sinusoid over at least a quarter of a cycle, comprising a plurality of ramp generators for generating a plurality of the ramp signals, the ramp signals being offset from one another either temporally or in value and further constrained to lie within a bounded range of values, and summing means for summing the ramp signals so as to form an approximated sinusoid.

29. An apparatus as claimed in claim 28 in which the outputs of the counters are constrained so as to be equal to or greater than zero.

30. An apparatus as claimed in claim 28 or 29 in which the ramp generators comprise at least one bi-directional counter.

Fig. 1

# Fig. 2

# Fig. 3

## Fig. 4

Fig. 5

EP 1 263 128 A2

## Fig. 6

## Fig. 7

## Fig. 8

2nd Order
Sine Synthesis

*31*

*21*

*29*

*27*

*7* Counter

Up/Down

*23* Counter

Shift
Register *25*

*9* Shift
Register

Clock

*11*

Fig. 9

Fig. 10

X-Axis

Y-Axis

15

# Fig. 11

EP 1 263 128 A2